# EUROPEAN PATENT SPECIFICATION

(11) **EP 3 159 432 B1**
(45) Date of publication and mention of the grant of the patent: **05.08.2020**
(21) Application number: 15191233.4
(22) Date of filing: 23.10.2015
(51) Int. Cl.: C23F 1/18, C23C 22/52, H05K 3/38

(54) **SURFACE TREATMENT AGENT FOR COPPER AND COPPER ALLOY SURFACES**
OBERFLÄCHENBEHANDLUNGSMITTEL FÜR KUPFER UND KUPFERLEGIERUNGSOBERFLÄCHEN
AGENT DE TRAITEMENT DE SURFACE POUR SURFACES EN ALLIAGE DE CUIVRE ET CUIVRE

(43) Date of publication of application: 26.04.2017
(73) Proprietor: Atotech Deutschland GmbH, 10553 Berlin (DE)
(72) Inventor: Cukic, Tatjana, 12059 Berlin (DE); Wood, Neal, Worcestershire, B98 8HX (GB); Hülsmann, Thomas, 14167 Berlin (DE)
(74) Representative: Atotech Deutschland GmbH

(56) References cited:
- US-A- 3 770 530
- US-A1- 2014 073 140
- US-B2- 7 232 528

## Description

### Field of the Invention

The present invention relates to a surface treatment solution for copper and copper alloys. Particularly, it relates to a surface treatment solution for copper and copper alloys which is useful in the field of electronics industry for producing printed circuit boards, IC substrates etc .

### Background of the Invention

In the production of printed circuit boards, the surface of copper is treated to promote the adhesion between the copper surface and a resist before coating the copper surface with a dry film of etching photoresists, solder resists, etc . The polishing method may include a mechanical polishing such as a buff polishing and a chemical polishing step. In the treatment of substrates carrying fine wiring pattern, the chemical polishing is usually used. In the production of multi-layered printed circuit boards, it has been attempted to promote the adhesion between a copper electroconductive patterned layer and a resin layer, for example, by forming an oxide layer on the copper surface and reducing the oxide layer to metallic copper by a reducing agent while maintaining the geometric shape of the oxide layer.

Japanese Patent Application Laid-Open No. 51-27819 proposes to etch copper or copper alloys with a hydrogen peroxide/sulphuric acid-based aqueous solution containing 5-aminotetrazole. However, since the copper surface is difficult to be made uniform by the proposed method, a part of the copper surface is likely to be poor in the adhesion to the resist.

Chinese patent no. 1177954 C discloses a micro-etching solution for copper surfaces using sulphuric acid, hydrogen peroxide, phenyltetrazole and chloride ions. However, such etching solutions do not allow for sufficient etching of copper surfaces resulting in merely superficially etched copper surfaces. This in turn gives insufficient adhesion strength values of organic matrices laminated to such treated copper surfaces (see example 5a).

Japanese patent application Laid-Open no. 2010-270365 and US 7,232,528 both try to improve such etching results and report independently a copper etching solution comprising an azole compound, a mineral acid, silver salts, hydrogen peroxide and halide ions. The use of a costly silver salt is highly undesired as the solubility product of silver and most halides is extremely low and below the required concentrations for useful treatments. Consequently, silver ions supplements do not even improve the etching results.

It is common that copper surfaces upon oxidative treatment become discoloured. A desired colour of an etched copper surface is slightly red to brown and matte. Such a colour is typically associated with a certain roughness which translates into good adhesion of laminates. However, the desired colour change depends also on the application. For copper layers which are present on the outer surface of the laminate reddish colours are desired (for example dry film and solder-resist applications) whereas darker colours may still be acceptable for multilayer applications where treated copper surfaces are kept within an organic matrix. Possible explanations for such a colour changes can also be a thin layer of copper oxide on the surface or the formation of organic copper complexes. Other discolourations are undesired and result in scrap production during manufacturing because many in-line analytical devices focus on the colour of copper surfaces.

US 3,770,530 A reports a Method of etching copper and alloys thereof which comprises conducting the etching by employing an acidic aqueous etching solution containing peroxysulfate, said etching solution further containing a triazoles or a tetrazole compound. Some examples also disclose the use of chloride ions and bromide ions. However, the proposed method only gives poor etching rates and is thus unsuitable for today's industries.

A further limitation of many methods described in the art is the occurrence of undesired haloing and undercuts when depositing final finishes such as immersion tin or ENIG (electroless nickel immersion gold) onto etched copper surfaces already bearing a solder mask or a photo-resist. Both, haloing and undercut can be a result of insufficient adhesion between a copper surface and an organic matrix. If upon treatment with a metal plating solution metal is deposited between an organic matrix and a copper surface (typically in the boundary areas of the two and underneath the organic matrix) then such metal deposits can typically be seen visually like pale spots or rings in microscopy. This is referred to as haloing.

Normally, organic matrices deposited onto etched copper surfaces should have rectangular edges. If either the deposition of the organic matrix itself or a metal plating process leaves such edges at odd angles forming a wedge-like form (visible in a cross-section for example) of the organic matrix, then this is referred to as undercut.

### Objective of the present Invention

It is therefore the objective of the present invention to provide a copper or copper alloy treatment solution overcoming the restrictions and disadvantages of the prior art. It is an objective to provide a copper or copper alloy treatment solution which allows for uniformly etched copper or copper alloy surfaces with a decisively improved intergranular attack thereon. Improved adhesion strength values of subsequently laminated organic matrices to such treated copper or copper alloy surfaces such as photo-resists (also referred to as photo-masks) or soldermasks (also referred to as solder-resists) are another objective of the present invention. Further, copper or copper alloy surfaces shall be of reddish colour making them also useful for solder resist dry film applications and haloing and undercuts are to be avoided.

### Summary of the Invention

Above-mentioned objectives are solved by the surface treatment solution for copper and copper alloy surfaces according to the invention comprising an acid, an azole corrosion inhibitor, an oxidising agent suitable to oxidise copper, at least one source of chloride ions and at least one source of bromide ions and that the oxidising agent suitable to oxidise copper is selected from the group consisting of hydrogen peroxide, metal peroxides, metal superoxides and mixtures thereof.

These objectives are further solved by the method for treating a copper or copper alloy surface according to the invention comprising the steps
(i) providing a substrate comprising at least one copper or copper alloy surface; and
(ii) treating at least a portion of said copper or copper alloy surface with the surface treatment solution according to the invention.

### Description of the Figures

Figure 1 is a SEM picture of a cross section of copper surface treated with a conventional etching solution for copper and copper alloy surfaces from the state of the art (example 3a). The surface shows very low penetration of the etching solution and a hair-like structure.
Figures 2 is a SEM pictures of a cross section of a copper surface treated with the surface treatment solution for copper and copper alloy surfaces according to the invention. Figure 2 relates to example 3c. Deep trench formation from the etching process is visible.

### Detailed Description of the Invention

The surface treatment solution for copper and copper alloy surfaces according to the invention comprising an acid, an azole corrosion inhibitor and an oxidising agent suitable to oxidise copper is characterised in that it further comprises at least one source of chloride ions and at least one source of bromide ions and that the oxidising agent suitable to oxidise copper is selected from the group consisting of hydrogen peroxide, metal peroxides, metal superoxides and mixtures thereof. This solution will be referred to herein as "surface treatment solution".

More preferably, the surface treatment solution according to the invention comprises a source of chloride ions wherein the concentration of chloride ions in the surface treatment solution ranges from 1 to 20 mg/L and a source of bromide iron wherein the concentration of bromide ions in the surface treatment solution ranges from 1 to 40 mg/L.

Even more preferably, the concentration of chloride ions in the surface treatment solution ranges from 5 to 10 mg/L and the concentration of bromide ions in the surface treatment solution ranges from 5 to 30 mg/L.

The surface treatment solution according to the invention contains at least one source of chloride ions. Suitable sources of chloride ions are water soluble chloride salts. Preferably, the at least one source of chloride ions is selected from the group consisting of hydrogen chloride, water soluble metal chlorides such as alkali chlorides like lithium chloride, sodium chloride, potassium chloride and caesium chloride, earth alkaline chlorides like manganese chloride, calcium chloride, strontium chloride and barium chloride, transition metal chlorides like manganese chloride, iron chloride, cobalt chloride, nickel chloride, copper chloride and zinc chloride, ammonium chloride and mixtures thereof. More preferably, the at least one source of chloride ions is selected from the group consisting of hydrogen chloride, alkali chlorides and ammonium chloride.

The surface treatment solution according to the invention contains at least one source of bromide ions. Suitable sources of bromide ions are water soluble bromide salts. Preferably, the at least one source of bromide ions is selected from the group consisting of hydrogen bromide, water soluble metal bromides such as alkali bromides like lithium bromide, sodium bromide, potassium bromide and caesium bromide, earth alkaline bromides like manganese bromide, calcium bromide, strontium bromide and barium bromide, transition metal bromides like manganese bromide, iron bromide, cobalt bromide, nickel bromide, copper bromide and zinc bromide, ammonium bromide and mixtures thereof. More preferably, the at least one source of bromide ions is selected from the group consisting of hydrogen bromide, alkali bromides, ammonium bromide and zinc bromide.

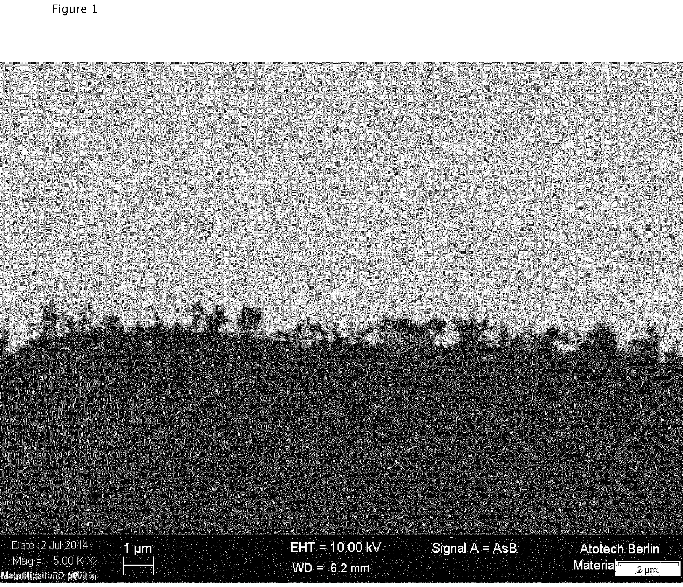

It was found by the inventors surprisingly and entirely unexpectedly that the use of at least one source of chloride ions and at least one source of bromide ions in a surface treatment solution results in several beneficial effects such as
a) an improved intergranular attack on the copper or copper alloy surface (see example 3 and figures 1 to 2) yielding deep trenches in the copper (alloy) surface;
b) an increased roughness of such treated copper and copper alloy surfaces (see example 2); and
c) significantly improved adhesion strength values of organic matrices laminated onto such treated copper or copper alloy surfaces (see e.g. examples 1 and 2).

The effect of the use of at least one source of chloride ions and at least one source of bromide ions on the adhesion strength values is synergistic as can be seen from example 2. Increased roughness is primarily understood herein that higher trench depth albeit with lower micro-roughness can be obtained (see figures 1 to 2).

Reflow treatments are processes in which typically a solder paste is used to temporarily or permanently attach one or more components to their contact pads in printed circuit manufacturing. Commonly, reflow treatments comprise several individual temperature profiles with temperature ramps and peaks. Peak temperatures which are necessary are typically well above 250 °C as this temperature is necessary to liquefy most solder pastes. These high temperatures are higher than the T_{g} values (glass transition state values) of most organic matrices (such as dielectric materials) and thence, reflow treatment often results in decreased adhesion strength values of copper surfaces and tin solders or organic matrices placed thereon. It is an advantage that this decrease is significantly reduced when using the surface treatment solution and the method according to the invention (see e.g. example 4).

The surface treatment solution according to the invention comprises at least one oxidising agent suitable to oxidise copper. The at least one oxidising agent suitable to oxidise copper is selected from the group consisting of hydrogen peroxide, metal peroxides such as sodium peroxide, potassium peroxide and metal superoxides such as potassium superoxide (KO₂) and mixtures thereof. To prevent decomposition of peroxides, other additional compounds such as *p*-phenolsulphonic acid can be added.

The concentration of the at least one oxidising agent preferably ranges from 0.5 to 10 wt.-%, more preferably from 1.0 to 5.0 wt.-%.

The surface treatment solution according to the invention comprises at least one acid preferably selected from sulphuric acid, methane sulphuric acid, nitric acid, phosphoric acid and mixtures thereof.

The concentration of the at least one acid preferably ranges from 10 to 250 g/L.

The surface treatment solution according to the invention comprises at least one azole corrosion inhibitor selected from the group consisting of benzotriazole, 5-methylbenzotriazole, 1*H*-1,2,3-methylbenzotriazole, imidazole, 1*H-*1,2,3-triazol, 4-methylthiazole, 3-amino-1*H*-1,2,4-triazole, 1*H*-tetrazole, 5-methyl-1*H*-tetrazole, 5-phenyl-1*H*-tetrazole and 5-amino-1*H*-tetrazole. Preferably, the azole corrosion inhibitor is selected from 1*H*-tetrazole, 5-methyl-1*H*-tetrazole, 5-phenyl-1*H*-tetrazole and 5-amino-1*H*-tetrazole as such tetrazole derivatives provide improved stability of the surface treatment solution. The addition of azole corrosion inhibitors advantageously reduces the corrosion of the metal surfaces to be treated due to the formation of a protective azole layer and sometimes they also decrease the formation of precipitates from the solution during use. Occasionally, after some copper dissolution from the copper or copper alloy surface precipitates are formed which limit the life-time of the surface treatment solution.

The concentration of the at least one azole corrosion inhibitor ranges from 0.01 to 2.0 wt.-%.

The surface treatment solution according to the invention optionally comprises at least one source of copper ions. Any water soluble copper salt is a possible source of copper ions, preferably copper (II) sulphate or a hydrate thereof is used. The concentration of the optional copper ions in the surface treatment solution ranges 1 to 50 g/L.

In one embodiment of the present invention, the surface treatment solution according to the invention is free of intentionally added silver ions (disregarding trace impurities commonly present in technical raw materials). Such silver ions disadvantageously reduce the amount of halide ions due to the extremely low solubility of silver halides in aqueous solutions and thus impair the etching properties of the surface treatment solution.

The surface treatment solution according to the invention is an aqueous solution. This means that the prevailing solvent is water. Other solvents which are miscible with water such as polar solvents including alcohols, glycols and glycol ethers may be added. For its ecologically benign characteristics it is preferred to use water only (*i.e.* more than 99 wt.-% based on all solvents).

The pH value of the surface treatment solution according to the invention preferably is ≤ 2, more preferably ≤ 1.

In one embodiment of the present invention, the surface treatment solution according to the invention comprises or consists of
a) at least one acid
b) at least one oxidising agent
c) at least one source of chloride ions
d) at least one source of bromide ions
e) at least one azole corrosion inhibitor.

In another embodiment of the present invention, the surface treatment solution according to the invention comprises or consists of
a) at least one acid
b) at least one oxidising agent
c) at least one source of chloride ions
d) at least one source of bromide ions
e) at least one azole corrosion inhibitor
f) at least one source of copper ions.

The surface treatment solution according to the invention can be prepared by dissolving all components in water. Should solubility issues arise pH ad-justors such as acids and based can be used to increase the solubility of the components to be dissolved. It can also be prepared by providing concentrates which are then diluted and/or mixed prior to use of the surface treatment solution according to the invention.

To increase the useful life of the surface treatment solution, it is a good idea to prepare the ready-for-use surface treatment solution right before carrying out the procedure. For example, hydrogen peroxide can be mixed with a sulphuric acid solution of the azole corrosion inhibitor and/or the source of copper ions, or a prepared solution can be supplemented directly before use to set the desired concentrations of individual components.

A mixture of at least one source of chloride ions and at least one source of bromide ions is used in a surface treatment solution for copper and copper alloys to etch said copper and copper alloy surfaces. Using such a mixture of at least one source of chloride ions and at least one source of bromide ions in a surface treatment solution for copper or copper alloys results in an improved attack of copper and copper alloy surfaces allowing *inter alia* for improved adhesion strength values of subsequently laminated organic matrices thereon.

The surface treatment solution according to the invention can be used for etching of copper and copper alloy surfaces, thus allowing for subsequently tightly bound organic matrices to the latter.

The method for treating a copper or copper alloy surface according to the invention comprises the steps
(i) providing a substrate comprising at least one copper or copper alloy surface; and
(ii) contacting at least a portion of said copper or copper alloy surface with the surface treatment solution according to the invention.

The steps are carried out in the order given above.

Substrates in the context of the present invention can be any substrate comprising at least one copper and copper alloy surface. Substrates can be made of copper or copper alloys in their entirety or alternatively, they comprise surfaces made of copper or copper alloys. Preferably, substrates are selected from copper foils, copper alloy foils, printed circuit boards, IC substrates, and copper clad laminates (CCL).

Copper surfaces are defined herein to be preferably made of 99 wt.-% or more of copper. Copper alloys preferably mean surfaces of 90 to 99 wt.-% copper with the balance being boron, silicon, phosphorous or another metal such as nickel, iron, cadmium and the like.

Particular preference is given to electrolytically deposited copper (alloy) surfaces, more preferably those having average grain sizes d₅₀ of 1 to 5 µm as determined by SEM (scanning electron microscopy).

Step (ii) is herein referred to as "treatment step". The contact of at least a portion of the copper or copper alloy surfaces with the surface treatment solution can be effected by any means known in the art. Typically, the surface treatment solution can be sprayed, wiped or otherwise brought onto the copper or copper alloy surface or the copper or copper alloy surface can be dipped or immersed into the surface treatment solution. The surface treatment solution can also be used in horizontal plating equipment, reel-to-reel, vertical and vertically conveyorized plating equipment.

The temperature of the surface treatment solution in step (ii) preferably ranges from 20 to 50 °C. Higher temperatures of the surface treatment solution result in faster etching processes of the copper or copper alloy surface. However, too high temperatures are detrimental to the stability of the surface treatment solution.

The time of contact of the surface treatment solution and the copper or copper alloy surface has to be adjusted to the temperature of the surface treatment solution. The time of contact of the surface treatment solution and the copper or copper alloy surface ranges typically from 5 to 300 seconds. In some cases, it is preferable to adjust the time of contact to the desired etch depths. This can be performed by routine experiments.

It is preferable to provide an air feed or oxygen feed into the surface treatment solution while contacting it to the copper or copper alloy surface. An air feed or oxygen feed can exemplarily be provided by bubbling these gases into the surface treatment solution. This improves the mixing and reduces the necessary treatment times and/or improves uniformity of the etching.

The method according to the invention may comprise rinsing steps with solvents such as water during the individual process steps. Particularly, after the contact of the copper or copper alloy surface with the surface treatment solution, it is advisable to rinse the copper or copper alloy surface with water to remove any undesired remnants of said solution. The method according to the invention may further comprise drying steps. It is possible for example to rinse the copper or copper alloy surface with hot water after the treatment step followed by drying with hot air or in an oven. Then, the copper or copper alloy surfaces may be immersed or treated otherwise with a dilute acid solution (e.g. 10 wt.-% hydrochloric acid or 10 wt.-% sulphuric acid) prior to any further processing.

The method for treating a copper or copper alloy surface according to the invention optionally further comprises the following step

### (ia) pre-treatment of the copper or copper alloy surface.

Step (ia) ("pre-treatment") is performed between steps (i) and (ii). Pre-treatment methods of copper and copper alloy surfaces are known in the art. Such pretreatment includes *inter alia* cleaning steps, removal of undesired layers such as chromate and/or oxide layers, and the deposition of organic monolayers (e.g. monolayers of azole corrosion inhibitors).

Cleaning of copper and copper alloy surfaces can be accomplished by various means known in the art. Typically, such cleaning steps use aqueous solutions which may be acidic or alkaline which optionally comprise surfactants and/or co-solvents such as glycols. Chromate layers can be removed by oxidative treatments employing for example aqueous solutions containing sodium persulphate and/or other oxidising agents. Oxide layers or other undesired residuals on the copper or copper alloy surface can be removed by alkaline aqueous treatments. Organic monolayers can be formed by treating copper or copper alloy surfaces with aqueous solutions comprising azole corrosion inhibitors such as benzotriazole.

The method for treating a copper or copper alloy surface according to the invention optionally and preferably further comprises the following step
(iii) contacting the copper or copper alloy surface with an alkaline post-dip.

This step is referred to as "alkaline post-dip step". Such alkaline post-dip helps to maintain the adhesion strength values of treated copper or copper alloy surfaces after reflow. Optional step (iii) (alkaline post-dip step) is included in the method for treating a copper or copper alloy surface according to the invention after step (ii) (treatment step). The contacting of the copper or copper alloy surface and the alkaline post-dip is selected from the same possibilities as given for the contact between the surface treatment solution and the copper or copper alloy surface in step (ii). The same or a different contact possibility may be chosen. If an alkaline post-dip step was performed, it is advantageous to rinse the copper or copper alloy surface thoroughly or to remove the alkaline residues therefrom otherwise prior to photoresist applications.

The alkaline post-dip is an aqueous solution containing at least one source of hydroxide ions (OH⁻). Such sources of hydroxide ions can be any watersoluble compounds which upon contact with water liberate or form otherwise hydroxide ions such as bases. Preferably, sources of hydroxide ions are selected from metal hydroxides such as alkali hydroxides and amines such as ammonia. The concentration of hydroxide ions in the alkaline post-dip preferably are at least 0.5 mol/L.

The method for treating a copper or copper alloy surface according to the invention optionally and preferably further comprises the following step
(iv) subjecting the substrate comprising at least one copper or copper alloy surface to elevated temperatures ranging from 90 to 200 °C.

This step is referred to as "heat-treatment step". The heat-treatment step reduces the adhesion strength value loss after reflow treatment. In combination with an alkaline post-dip step (optional step (iii)) the effect of reduction of adhesion strength value loss after reflow treatment is even more pronounced. Optional step (iv) is included in the method for treating a copper or copper alloy surface according to the invention after step (ii). If the method according to the invention comprises also optional step (iii) (alkaline post-dip step), the heat treatment step is performed after the alkaline post-dip step.

The duration of the heat-treatment step is dependent on the temperature used. Typically, the heat-treatment lasts for 60 to 120 min. However, longer or shorter durations can be employed depending on the desired effects.

The elevated temperatures can be provided by many means known in the art and those means are not particularly limited. The copper or copper alloy surfaces can be placed in an oven using e.g. a resistance furnace; they can be irradiated with electromagnetic radiation (employing e.g. infrared heaters) or can be heat treated by any other means.

The substrate comprising at least one copper or copper alloy surface is more preferably subjected to elevated temperatures ranging from 90 to 200 °C. The substrate comprising at least one copper or copper alloy surface is typically subjected to elevated temperatures for 30 to 120 min. The time for the heat treatment step is also dependent on the temperature chosen and may be outside said ranges. Generally, if the substrate is treated for too short a period the adhesion strength value loss after reflow is not sufficiently averted. If the substrate is treated for too long a period at elevated temperatures, the cosmetic appearance may be impaired and an undesired discolouration may occur.

In an even more preferred embodiment, the method for treating a copper or copper alloy surface according to the invention includes optional steps (iii) and (iv) (see example 5).

The method for treating a copper or copper alloy surface according to the invention optionally and preferably further comprises the following step
(v) laminating an organic matrix onto the treated copper or copper alloy surface.

Organic matrices include but are not limited to prepregs, solder masks, photo-resists and the like. Prepregs are fibre-reinforced plastics, typically glass-reinforced epoxy-matrices are used such as FR-4 and FR-5.

Alternatively to step (v) or further to laminating an organic matrix onto the treated copper or copper alloy surface, it is possible to deposit a final finish on the treated copper or copper alloy surfaces or portions thereof including such finishes as immersion tin, electroless nickel immersion gold (ENIG), electroless nickel electroless palladium electroless gold (ENEPIG), electroless palladium electroless gold (EPIG), immersion silver, organic solder preservatives (OSP) and the like. These finishes are well-established in the art.

Useful tin deposition methods e.g. include immersion tin plating as described in EP 2476779 B1.

It is an advantage of the present invention that haloing and the formation of undercuts can be prevented when treating a copper or copper alloy surface with the surface treatment solution and the method according to the invention (see example 6).

The following non-limiting examples further illustrate the present invention.

### Examples

ED copper foils used in the experiments had an average grain size of 0.5-3 µm as determined by SEM of electro-polished samples. The surface treatment solutions were prepared by dissolving all components in water or if necessary in dilute sodium hydroxide solution.

### Adhesion strength values

The adhesion between the treated copper surface and the organic matrix was measured. Adhesion strength values (also referred to as peel strength values) were measured according to the method described in IPC-TM-650 Test Methods Manual Number 2.4.8 revision C.

### Surface roughness

The smoothness of the outer surface was determined by a scanning atomic force microscope (Digital Instruments, NanoScope equipped with a PointProbe® from Nanosensors with a tip radius of less than 7 nm), scan size: 5 x 5 µm, scan in tapping mode. RSAI values (relative surface area increase) were obtained by these measurements and are provided with the respective examples below.

### SEM observations

The microscopic characterisation of the copper surfaces was performed using Carl Zeiss SMT Ltd. EVO15-07.05 or a Helios NanoLab 650 scanning electron microscopes (SEM, both FEI Company). Trench depths were measured by SEM on a cross section.

### Reflow treatment

The substrates were subjected to a reflow treatment in a 5 zone furnace with an overall length of the heated zone of 246 cm. The peak temperature was 280 °C. The other zones were of 160 °C, 180 °C, 195 °C, 210 °C and the transport speed was 60 cm/min. The reflow treatment was carried out under nitrogen atmosphere. This reflow treatment was repeated five times in total such that the overall dwell time in the heated zone added up to approximately 20.5 min.

### Mean trench depth

Mean trench depth is the average value of trench depths measured via SEM. At least five different values were measured from the respective peaks of the remaining copper surface to the neighbouring recesses (see also figures 1 to 2). Then, the average value was calculated.

### Example 1: Bromide Ion Concentration Dependency of Adhesion Strength Values

Aqueous surface treatment solutions each containing 50 mL/L hydrogen peroxide (35 wt.-%), 130 mL/L sulphuric acid (50 wt.-%), 0.7 g/L azole corrosion inhibitor and 10 mg/L of chloride ions (provided as sodium chloride) and varying amounts of bromide ions (provided as sodium bromide) as given in the following table were prepared.

ED copper foils were pre-treated with an aqueous solution containing 150 g/L sodium persulphate and 130 mL/L sulphuric acid (50 wt.-%) at 35 °C for 15 seconds to remove the chromate layer. After rinsing with deionised water, they were cleaned with 100 mL/L BondFilm Cleaner ALK conc. (product of Atotech Deutschland GmbH) in deionised water for 3 minutes at 50°C. After a further rinse with deionised water, such treated ED copper foils were immersed into above-described surface treatment solution at 45°C for approximately 60 seconds. The treatment time was adjusted in order to have comparable etch depths as given in the following tables for all test specimens. After a further rinse, the samples were dried with hot air (60 °C).

All samples were laminated in a multilayer press with prepregs according to the specifications given in the respective material data sheets. During this procedure, the semi-cured epoxy prepreg layer was cured and bonded to the treated copper metal surface. Isola 104 ML FR-4 ("FR-4") from Isola Group S.a.r.l. were used as prepreg (T_{g}=135 °C). The adhesing strength values were measured and the results are listed in Table 1.

**Table 1: Adhesion strength values on FR-4 prepregs.**

| Example no. | Trench depth c (Br⁻) | Adhesion strength [N/cm] | | |
|---|---|---|---|---|
| | | 0.5 µm | 0.8 µm | 1.0 µm |
| 1a comparative | 0 mg/L | 4.6 | 6.5 | 7.2 |
| 1b inventive | 5 mg/L | 6.0 | 8.3 | 9.2 |
| 1c inventive | 10 mg/L | 6.0 | 8.3 | 9.6 |

It can be seen that the adhesion strength increases upon addition of bromide ions to the surface treatment solution. This improved adhesion strength is also independent on the trench depth.

### Example 2: Synergistic Effect of chloride ions and bromide ions

Aqueous surface treatment solutions each containing 35 mL/L hydrogen peroxide (35 wt.-%), 130 mL/L sulphuric acid (50 wt.-%), 10 g/L azole corrosion inhibitor and chloride ions (provided as sodium chloride) and bromide ions (provided as sodium bromide) in concentrations as given in the following table were prepared. The surface treatment solutions were used directly after make-up (day 1 in the following table) and after being stored for 1 day (day 2).

ED copper foils were pre-treated with an aqueous solution containing 150 g/L sodium persulphate and 130 mL/L sulphuric acid (50 wt.-%) at 35 °C for 15 seconds to remove the chromate layer. After rinsing with deionised water, they were immersed into an aqueous solution of 100 mL/L BondFilm Cleaner UC conc. (product of Atotech Deutschland GmbH) in deionised water for 3 minutes at 50 °C, rinsed again with deionised water, and cleaned with 100 mL/L BondFilm Cleaner ALK conc. (product of Atotech Deutschland GmbH) in deionised water for 3 minutes at 50 °C. After a further rinse with deionised water, such treated ED copper foils were immersed into above-described surface treatment solution at 45 °C for approximately 60 seconds. The treatment time was adjusted in order to have comparable etch depths as given in the following table for all test specimens. After rinsing again, the samples were dried with fan blower at 60 °C. Samples were laminated onto prepregs as described in example 1. The results of the adhesion strength value and surface roughness measurements are summarized in Table 2.

**Table 2: Adhesion strength values of copper surfaces treated with surface treatment solutions, etch depth 1.2 µm.**

| | c (Cl⁻) [mmol/L] | c (Br⁻) [mmol/L] | Adhesion strength value [N/cm] | | RSAl [%] |
|---|---|---|---|---|---|
| | | | Day 1 | Day 2 | |
| 2a comparative | 0 | 0.56 | 7 | 2.3 | 90 |
| 2b comparative | 0.28 | 0 | 6.3 | - | 105 |
| 2c inventive | 0.28 | 0.28 | 7.8 | 8.0 | 170 |
| 2d comparative | 0.56 | 0 | 7.2 | 7.2 | 150 |

The ED foils treated with the surface treatment solution comprising only bromide ions (comparative example 2a) yielded good initial adhesion strength values but these values deteriorated quickly and after one day only negligible adhesion strength values were obtained.

Comparative example 2b and 2d comprised only chloride ions and no bromide ions. The initial adhesion strength values were comparable to those of comparative example 2a and the adhesion strength loss was less pronounced in case of higher concentrations of chloride ions.

In comparison to the surface treatment solution comprising only one source of halide ions, inventive example 2c gave even better adhesion strength values due to a synergistic effect of the two sources of halide ions present in the surface treatment solution. There was no adhesion strength loss when using an aged surface treatment solution (day 2), the roughness was even more pronounced than in the case of the high concentration of chloride ions (example 2d) and the copper foils with the desired darkish brownish colour.

And importantly, the adhesion strength values were even higher for inventive example 2c than for comparative examples 2a and 2d which contained the same amount of substance of halide ions but comprised only one type of halide ions, namely chloride or bromide. Further, the surface roughness was measured for all samples and the increase was highest for the inventive example 2c.

### Example 3: Mean trench depth over time

The surface treatment solutions of example 1 were used to treat ED copper foils which as described in example 1 for a given treatment time of 60 s. Then, the mean trench depth was measured as a function of bromide ion concentration. The results are summarized in Table 3.

**Table 3: Measured mean trench depth on FR-4 (etch depth 0.8 µm)**

| Example no. | c(Br⁻) | Mean trench depth |
|---|---|---|
| 3a Comparative | 0 mg/L | 0.7 µm |
| 3b Inventive | 5 mg/L | 1.2 µm |
| 3c Inventive | 10 mg/L | 1.2 µm |

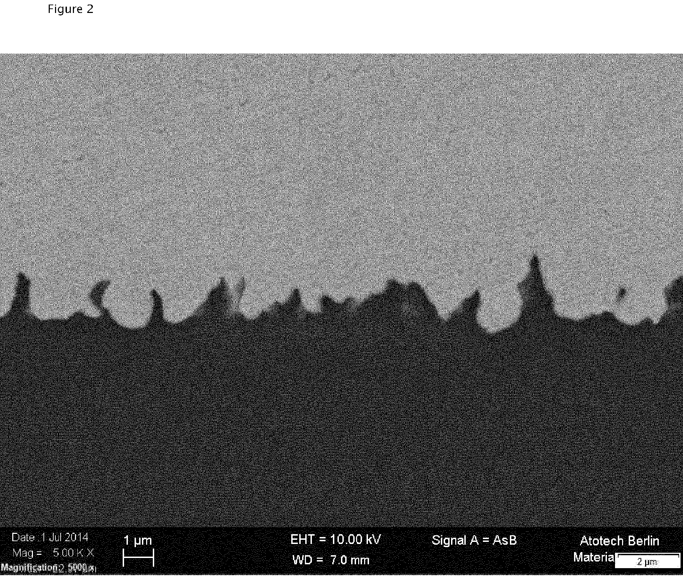

The SEM pictures are shown in figures 1 to 2. Figure 1 corresponds to example 3a and Figure 2 to example 3c. It can be seen from Figure 1 that the etching with the surface treatment solution of comparative example 3a resulted in a hair-like structure with very low penetration depth. Contrary to the comparative examples, the inventive surface treatment solution resulted in much more strongly etched structures. Deep trenches were formed. The effect of the inventive surface treatment solutions was a much more pronounced intergranular attack on the individual copper grains resulting in much deeper trenches corresponding to higher mean trench values (see example 1).

### Example 4: Influence of Alkaline post-dip (step (iii)) and subjection to elevated temperatures (step (iv))

An aqueous surface treatment solution containing 50 mL/L hydrogen peroxide (35 wt.-%), 130 mL/L sulphuric acid (50 wt.-%), 0.7 g/L azole corrosion inhibitor and 10 mg/L of chloride ions (provided as sodium chloride) and 5 mg/L of bromide ions (provided as sodium bromide) and 20 g/L copper sulphate pentahydrate was prepared.

ED copper foils were pre-treated with an aqueous solution of 150 g/L sodium persulphate and 130 mL/L sulphuric acid (50 wt.-%) for 15 seconds to remove the chromate layer. After rinsing with deionised water, they were cleaned with 100 mL/L Basiclean™ ALK (product of Atotech Deutschland GmbH) in deionised water for 3 minutes at 50°C. After a further rinse with deionised water, such treated ED copper foils were immersed into above-described surface treatment solution at 45°C for 60 seconds. They were laminated onto FR-4 as described in example 1. Half of the samples were subjected to a reflow treatment. The adhesion strength values were then measured.

Example 4a was neither treated with an alkaline post-dip (step (iii)) nor with elevated temperatures (heat-treatment step, step(iv)). Examples 4b and 4c where heat-treated for 60 and 120 minutes, respectively. Examples 4d to 4f were treated with an aqueous alkaline solution of 100 mL/L Basiclean™ ALK (Alkaline post-dip step, 50 °C, 30 s).

Examples 4e and 4f were also heat-treated. The etch depth was 0.8 µm in all cases. The results are summarized in Table 4. The adhesion strength values after reflow are given as percentage of the respective value before reflow (exemplarily, 4a: before reflow 8.0, after reflow only 32.5% thereof corresponds to 2.6).

**Table 4: Influence of alkaline post-dip and heat-treatment step on adhesion strength values.**

| Example no. | Alkaline Post-dip | Time at 150 °C [min] | Adhesion strength value [N/cm] | |
|---|---|---|---|---|
| | | | Before reflow | After reflow |
| 4a | No | 0 | 8.0 | 32.5% |
| 4b | No | 60 | 7.7 | 72.7% |
| 4c | No | 120 | 4.8 | 100% |
| 4d | Yes | 0 | 8.6 | 34.9% |
| 4e | Yes | 60 | 7.7 | 72.7% |
| 4f | Yes | 120 | 8.0 | 72.5% |

In all cases, the use of a heat-treatment step improves the adhesion strength values after reflow treatment. Without heat-treatment step, the loss of the initially achieved adhesion strength value before reflow dropped by approximately two thirds (4a, 4d). When using the heat-treatment step, the loss could be entirely avoided (4c) or at least reduced to less than 30% of the initial adhesion strength value before reflow.

The use of the alkaline post-dip step also improved the adhesion strength values before and after reflow. Too long heat-treatment steps resulted in a loss of adhesion strength values before reflow (see 4c). This could be remedied by the use of the alkaline post-dip step (4f). Thus, the alkaline post-dip step also advantageously limits losses of adhesions strength resulting from too long treatments in the heat-treatment step.

### Example 5: Bromide Ion Concentration Dependency of Adhesion Strength Values

Aqueous surface treatment solutions each containing 50 mL/L hydrogen peroxide (35 wt.-%), 50 mL/L sulphuric acid (98 wt.-%), 0.7 g/L azole corrosion inhibitor, 20 g/L copper sulphate pentahydrate (corresponds approximately to 5.09 g/L copper ions) and varying amounts of chloride and bromide ions (each provided as respective sodium salts) as given in the following table were prepared.

Copper foils were immersed at 45 °C into above-described surface treatment solution without any pretreatment until an etch depth of 1.0 µm was reached.

Such treated copper foils were laminated on FR-4 prepregs as described in example 1 and the adhesion strength values of these laminates were measured. The results are summarized in Table 5.

**Table 5: Adhesion strength values on FR-4 prepregs.**

| Example no. | c(Cl⁻) | c (Br⁻) | Adhesion strength values [N/cm] |
|---|---|---|---|
| 5a Comparative | 5 mg/L | 0 mg/L | 7.1 |
| 5b Comparative | 10 mg/L | 0 mg/L | 8.5 |
| 5c Comparative | 15 mg/L | 0 mg/L | 8.3 |
| 5d Inventive | 10 mg/L | 5 mg/L | 9.6 |
| 5e Inventive | 15 mg/L | 5 mg/L | 8.9 |
| 5f Inventive | 15 mg/L | 10 mg/L | 9.3 |

The adhesion strength values for the comparative examples ranged from 7.1 to 8.5 N/cm with the maximum obtained for 10 mg/L chloride. Higher concentrations thereof had a detrimental effect resulting in a slight decrease of the adhesion strength. The combination of chloride and bromide ions in the etching solution gave better adhesions of up to 9.6 N/cm for 15 mg/L overall halide concentration. Again, higher total concentrations did not improve the results but still showed better adhesion strength values than the etching solutions comprising only one halide ion.

A synergistic effect was observed as the overall concentration of halide ions in comparative example 5c and inventive example 5d was the same but the adhesion strength was much better in the latter case which employed a surface treatment solution according to the invention.

### Example 6: Solder mask applications

Aqueous surface treatment solutions each containing 50 mL/L hydrogen peroxide (35 wt.-%), 50 mL/L sulphuric acid (98 wt.-%), 0.7 g/L azole corrosion inhibitor, 20 g/L copper sulphate pentahydrate (corresponds to approximately 5.09 g/L copper ions), 10 mg/L of chloride ions (added as 0.1 M hydrochloric acid) and varying amounts of bromide ions (provided as sodium bromide) as given in the following table were prepared.

CCL panels were immersed into above-described surface treatment solution (45 °C, 60 seconds) without any pretreatment. After rinsing with deionised water and drying, the colour of the copper surfaces was inspected.

A solder mask was laminated onto the CCL panels, thereby forming a circuit pattern. Then, immersion tin was deposited (Stannatech® 1000-V, product of Atotech Deutschland GmbH, parameters as given in the technical datasheet were used) as final finish and the panels were analysed with high resolution microscopy for any haloing or undercuts. The results are summarized in Table 6.

**Table 6: Solder mask applications and cosmetic appearance.**

| Example no. | c(Br⁻) | Colour of copper surface | Haloing / undercut |
|---|---|---|---|
| 6a. Comparative | 0 mg/L | Salmon pink | yes / yes |
| 6b. Inventive | 1 mg/L | Darker than 6a. | no / no |
| 6c. Inventive | 2 mg/L | Reddish | no / no |
| 6d. Inventive | 3 mg/L | Reddish | no / no |
| 6e. Inventive | 5 mg/L | Reddish | no / no |
| 6f. Inventive | 10 mg/L | Reddish | no / no |
| 6g. Inventive | 20 mg/L | Less red than 6f. | no / no |
| 6h. Inventive | 30 mg/L | Salmon pink | no / no |

The CCL panels treated with a surface solution according to the invention showed neither undercuts nor haloing. Contrary to that, the omission of bromide ions resulted in these two undesired effects after immersion tin deposition. The appearance of the CCL panels of inventive examples 6b to 6f was as desired having a red colour. Those CCL panels treated with higher amounts of bromide ions in the surface treatment solution were of lighter colour shades but the colour of example 6h changed in the subsequent two days to a red colour comparable to examples 6b to 6f. The comparative CCL panel was salmon pink which might cause problems with standard in-line analytical tools during manufacturing.

Other embodiments of the present invention will be apparent to those skilled in the art from a consideration of this specification or practice of the invention disclosed herein. It is intended that the specification and examples be considered as exemplary only, with the true scope of the invention being defined by the following claims only.

## Claims

1. A surface treatment solution for copper and copper alloy surfaces comprising an acid, an azole corrosion inhibitor and an oxidising agent suitable to oxidise copper **characterised in that** it further comprises at least one source of chloride ions and at least one source of bromide ions and that the oxidising agent suitable to oxidise copper is selected from the group consisting of hydrogen peroxide, metal peroxides, metal superoxides and mixtures thereof.

2. The surface treatment solution for copper and copper alloy surfaces according to claim 1 **characterised in that** the concentration of chloride ions in the surface treatment solution ranges from 1 to 20 mg/L and the concentration of bromide ions in the surface treatment solution ranges from 1 to 40 mg/L.

3. The surface treatment solution for copper and copper alloy surfaces according to claim 2 **characterised in that** the concentration of chloride ions in the surface treatment solution ranges from 5 to 10 mg/L and the concentration of bromide ions in the surface treatment solution ranges from 5 to 30 mg/L.

4. The surface treatment solution for copper and copper alloy surfaces according to any one of the preceding claims **characterised in that** the source of chloride ions is a water soluble chloride salt and the source of bromide ions is a water soluble bromide salt.

5. The surface treatment solution for copper and copper alloy surfaces according to any one of the preceding claims **characterised in that** the source of chloride ions is selected from the group consisting of hydrogen chloride, water soluble metal chlorides, ammonium chloride and mixtures thereof.

6. The surface treatment solution for copper and copper alloy surfaces according to any one of the preceding claims **characterised in that** the source of bromide ions is selected from the group consisting of hydrogen bromide, water soluble metal bromides, ammonium bromide and mixtures thereof.

7. The surface treatment solution for copper and copper alloy surfaces according to any one of the preceding claims **characterised in that** the acid is selected from sulphuric acid, methane sulphuric acid, nitric acid, phosphoric acid and mixtures thereof.

8. The surface treatment solution for copper and copper alloy surfaces according to any one of the preceding claims **characterised in that** it comprises at least one azole corrosion inhibitor selected from the group consisting of benzotriazole, 5-methylbenzotriazole, 1*H*-1,2,3-methylbenzotriazole, imidazole, 1*H*-1,2,3-triazol, 4-methylthiazole, 3-amino-1*H*-1,2,4-triazole, 1*H*-tetrazole, 5-methyl-1*H*-tetrazole, 5-phenyl-1*H-*tetrazole and 5-amino-1*H*-tetrazole.

9. The method for treating a copper or copper alloy surface comprising the steps
(i) providing a substrate comprising at least one copper or copper alloy surface; and
(ii) contacting at least a portion of said copper or copper alloy surface with the surface treatment solution according to any one of claims 1 to 8.

10. The method for treating a copper or copper alloy surface according to claim 9 **characterised in that** the substrate comprising at least one copper or copper alloy surface is selected from copper foils, copper alloy foils, printed circuit boards, IC substrates, and copper clad laminates (CCL).

11. The method for treating a copper or copper alloy surface according to claims 9 or 10 **characterised in that** it further comprises the following step
(iii) contacting the copper or copper alloy surface with an alkaline post-dip.

12. The method for treating a copper or copper alloy surface according to any one of claims 9 to 11 **characterised in that** it further comprises the following step
(iv) subjecting the substrate comprising at least one copper or copper alloy surface to elevated temperatures ranging from 90 to 200 °C.

13. The method for treating a copper or copper alloy surface according to any one of claims 9 to 12 **characterised in that** it further comprises the following step
(v) laminating an organic substrate onto the treated copper or copper alloy surface.

## Patentansprüche

1. Oberflächenbehandlungslösung für Kupfer- und Kupferlegierungsoberflächen, umfassend eine Säure, einen Azol-Korrosionsinhibitor und ein für die Oxidation von Kupfer geeignetes Oxidationsmittel, **dadurch gekennzeichnet, dass** sie ferner mindestens eine Quelle von Chloridionen und mindestens eine Quelle von Bromidionen umfasst und dass das für die Oxidation von Kupfer geeignete Oxidationsmittel aus der Gruppe bestehend aus Wasserstoffperoxid, Metallperoxiden, Metallsuperoxiden und Mischungen davon ausgewählt ist.

2. Oberflächenbehandlungslösung für Kupfer- und Kupferlegierungsoberflächen nach Anspruch 1, **dadurch gekennzeichnet, dass** die Konzentration von Chloridionen in der Oberflächenbehandlungslösung im Bereich von 1 bis 20 mg/L liegt und die Konzentration von Bromidionen in der Oberflächenbehandlungslösung im Bereich von 1 bis 40 mg/L liegt.

3. Oberflächenbehandlungslösung für Kupfer- und Kupferlegierungsoberflächen nach Anspruch 2, **dadurch gekennzeichnet, dass** die Konzentration von Chloridionen in der Oberflächenbehandlungslösung im Bereich von 5 bis 10 mg/L liegt und die Konzentration von Bromidionen in der Oberflächenbehandlungslösung im Bereich von 5 bis 30 mg/L liegt.

4. Oberflächenbehandlungslösung für Kupfer- und Kupferlegierungsoberflächen nach einem der vorhergehenden Ansprüche, **dadurch gekennzeichnet, dass** es sich bei der Quelle von Chloridionen um ein wasserlösliches Chloridsalz handelt und es sich bei der Quelle von Bromidionen um ein wasserlösliches Bromidsalz handelt.

5. Oberflächenbehandlungslösung für Kupfer- und Kupferlegierungsoberflächen nach einem der vorhergehenden Ansprüche, **dadurch gekennzeichnet, dass** die Quelle von Chloridionen aus der Gruppe bestehend aus Chlorwasserstoff, wasserlöslichen Metallchloriden, Ammoniumchlorid und Mischungen davon ausgewählt ist.

6. Oberflächenbehandlungslösung für Kupfer- und Kupferlegierungsoberflächen nach einem der vorhergehenden Ansprüche, **dadurch gekennzeichnet, dass** die Quelle von Bromidionen aus der Gruppe bestehend aus Bromwasserstoff, wasserlöslichen Metallbromiden, Ammoniumbromid und Mischungen davon ausgewählt ist.

7. Oberflächenbehandlungslösung für Kupfer- und Kupferlegierungsoberflächen nach einem der vorhergehenden Ansprüche, **dadurch gekennzeichnet, dass** die Säure aus Schwefelsäure, Methanschwefelsäure, Salpetersäure, Phosphorsäure und Mischungen davon ausgewählt ist.

8. Oberflächenbehandlungslösung für Kupfer- und Kupferlegierungsoberflächen nach einem der vorhergehenden Ansprüche, **dadurch gekennzeichnet, dass** sie mindestens einen Azol-Korrosionsinhibitor aus der Gruppe bestehend aus Benzotriazol, 5-Methylbenzotriazol, 1*H*-1,2,3-Methylbenzotriazol, Imidazol, 1*H*-1,2,3-Triazol, 4-Methylthiazol, 3-Amino-1*H*-1,2,4-triazol, 1*H*-Tetrazol, 5-Methyl-1*H-*tetrazol, 5-Phenyl-1*H*-tetrazol und 5-Amino-1*H-*tetrazol umfasst.

9. Verfahren zum Behandeln einer Kupfer- oder Kupferlegierungsoberfläche, umfassend die Schritte
(i) Bereitstellen eines Substrats, das mindestens eine Kupfer- oder Kupferlegierungsoberfläche umfasst; und
(ii) Inkontaktbringen mindestens eines Teils der Kupfer- oder Kupferlegierungsoberfläche mit der Oberflächenbehandlungslösung nach einem der Ansprüche 1 bis 8.

10. Verfahren zum Behandeln einer Kupfer- oder Kupferlegierungsoberfläche nach Anspruch 9, **dadurch gekennzeichnet, dass** das Substrat, das mindestens eine Kupfer- oder Kupferlegierungsoberfläche umfasst, aus Kupferfolien, Kupferlegierungsfolien, gedruckten Leiterplatten, IC-Substraten und kupferkaschierten Laminaten (Copper Clad Laminates, CCL) ausgewählt ist.

11. Verfahren zum Behandeln einer Kupfer- oder Kupferlegierungsoberfläche nach Anspruch 9 oder 10, **dadurch gekennzeichnet, dass** es ferner den folgenden Schritt umfasst:
(iii) Inkontaktbringen der Kupfer- oder Kupferlegierungsoberfläche mit einem alkalischen Nacheintauchmittel.

12. Verfahren zum Behandeln einer Kupfer- oder Kupferlegierungsoberfläche nach einem der Ansprüche 9 bis 11, **dadurch gekennzeichnet, dass** es ferner den folgenden Schritt umfasst:
(iv) Einwirkenlassen von erhöhten Temperaturen im Bereich von 90 bis 200 °C auf das Substrat, das mindestens eine Kupfer- oder Kupferlegierungsoberfläche umfasst.

13. Verfahren zum Behandeln einer Kupfer- oder Kupferlegierungsoberfläche nach einem der Ansprüche 9 bis 12, **dadurch gekennzeichnet, dass** es ferner den folgenden Schritt umfasst:
(v) Auflaminieren eines organischen Substrats auf die behandelte Kupfer- oder Kupferlegierungsoberfläche.

## Revendications

1. Solution de traitement de surface pour des surfaces de cuivre et d'alliage de cuivre comprenant un acide, un inhibiteur de corrosion de type azole et un agent oxydant approprié pour oxyder du cuivre, **caractérisée en ce qu'**elle comprend en outre au moins une source d'ions chlorure et au moins une source d'ions bromure et **en ce que** l'agent oxydant approprié pour oxyder du cuivre est choisi dans le groupe constitué par le peroxyde d'hydrogène, des peroxydes métalliques, des superoxydes métalliques et des mélanges correspondants.

2. Solution de traitement de surface pour des surfaces de cuivre et d'alliage de cuivre selon la revendication 1 **caractérisée en ce que** la concentration d'ions chlorure dans la solution de traitement de surface se situe dans la plage de 1 à 20 mg/L et la concentration d'ions bromure dans la solution de traitement de surface se situe dans la plage de 1 à 40 mg/L.

3. Solution de traitement de surface pour des surfaces de cuivre et d'alliage de cuivre selon la revendication 2 **caractérisée en ce que** la concentration d'ions chlorure dans la solution de traitement de surface se situe dans la plage de 5 à 10 mg/L et la concentration d'ions bromure dans la solution de traitement de surface se situe dans la plage de 5 à 30 mg/L.

4. Solution de traitement de surface pour des surfaces de cuivre et d'alliage de cuivre selon l'une quelconque des revendications précédentes **caractérisée en ce que** la source d'ions chlorure est un sel de chlorure soluble dans l'eau et la source d'ions bromure est un sel de bromure soluble dans l'eau.

5. Solution de traitement de surface pour des surfaces de cuivre et d'alliage de cuivre selon l'une quelconque des revendications précédentes **caractérisée en ce que** la source d'ions chlorure est choisie dans le groupe constitué par le chlorure d'hydrogène, des chlorures métalliques solubles dans l'eau, le chlorure d'ammonium et des mélanges correspondants.

6. Solution de traitement de surface pour des surfaces de cuivre et d'alliage de cuivre selon l'une quelconque des revendications précédentes **caractérisée en ce que** la source d'ions bromure est choisie dans le groupe constitué par le bromure d'hydrogène, des bromures métalliques solubles dans l'eau, le bromure d'ammonium et des mélanges correspondants.

7. Solution de traitement de surface pour des surfaces de cuivre et d'alliage de cuivre selon l'une quelconque des revendications précédentes **caractérisée en ce que** l'acide est choisi parmi l'acide sulfurique, l'acide méthanesulfurique, l'acide nitrique, l'acide phosphorique et des mélanges correspondants.

8. Solution de traitement de surface pour des surfaces de cuivre et d'alliage de cuivre selon l'une quelconque des revendications précédentes **caractérisée en ce qu'**elle comprend au moins un inhibiteur de corrosion de type azole choisi dans le groupe constitué par le benzotriazole, le 5-méthylbenzotriazole, le 1*H*-1,2,3-méthyl-benzotriazole, l'imidazole, le 1*H*-1,2,3-triazole, le 4-méthylthiazole, le 3-amino-1*H*-1,2,4-triazole, le 1*H*-tétrazole, le 5-méthyl-1*H*-tétrazole, le 5-phényl-1*H*-tétrazole et le 5-amino-1*H*-tétrazole.

9. Procédé pour le traitement d'une surface de cuivre ou d'alliage de cuivre comprenant les étapes de
(i) mise à disposition d'un substrat comprenant au moins une surface de cuivre ou d'alliage de cuivre ; et
(ii) mise en contact d'au moins une partie de ladite surface de cuivre ou d'alliage de cuivre avec la solution de traitement de surface selon l'une quelconque des revendications 1 à 8.

10. Procédé pour le traitement d'une surface de cuivre ou d'alliage de cuivre selon la revendication 9 **caractérisé en ce que** le substrat comprenant au moins une surface de cuivre ou d'alliage de cuivre est choisi parmi des feuilles de cuivre, des feuilles d'alliage de cuivre, des panneaux de circuit imprimé, des substrats de CI, et des stratifiés plaqués de cuivre (SPC).

11. Procédé pour le traitement d'une surface de cuivre ou d'alliage de cuivre selon la revendication 9 ou 10 **caractérisé en ce qu'**il comprend en outre l'étape suivante de
(iii) mise en contact de la surface de cuivre ou d'alliage de cuivre avec un bain alcalin de post-trempage.

12. Procédé pour le traitement d'une surface de cuivre ou d'alliage de cuivre selon l'une quelconque des revendications 9 à 11 **caractérisé en ce qu'**il comprend en outre l'étape suivante de
(iv) soumission du substrat comprenant au moins une surface de cuivre ou d'alliage de cuivre à des températures élevées dans la plage de 90 à 200 °C.

13. Procédé pour le traitement d'une surface de cuivre ou d'alliage de cuivre selon l'une quelconque des revendication 9 à 12 **caractérisé en ce qu'**il comprend en outre l'étape suivante de
(v) stratification d'un substrat organique sur la surface de cuivre ou d'alliage de cuivre traitée.
